# EUROPÄISCHE PATENTSCHRIFT

(11) **EP 1 312 124 B1**
(45) Veröffentlichungstag und Bekanntmachung des Hinweises auf die Patenterteilung: **01.10.2014**
(21) Anmeldenummer: 01971630.7
(22) Anmeldetag: 22.08.2001
(51) Int. Cl.: H01L 33/48, H01L 31/0203

(54) **OPTOELEKTRONISCHES BAUELEMENT UND VERFAHREN ZU DESSEN HERSTELLUNG, MODUL UND VORRICHTUNG MIT EINEM SOLCHEN MODUL**
OPTOELECTRONIC COMPONENT AND METHOD FOR THE PRODUCTION THEREOF, MODULE AND DEVICE COMPRISING A MODULE OF THIS TYPE
COMPOSANT OPTOELECTRONIQUE ET SON PROCEDE DE PRODUCTION, MODULE ET DISPOSITIF COMPRENANT UN TEL COMPOSANT

(30) Priorität: 23.08.2000 DE 10041328
(43) Veröffentlichungstag der Anmeldung: 21.05.2003
(73) Patentinhaber: OSRAM Opto Semiconductors GmbH, 93055 Regensburg (DE)
(72) Erfinder: BOGNER, Georg, 93138 Lappersdorf (DE); BRUNNER, Herbert, 93047 Regensburg (DE); LEX, Wolfgang, 93092 Barbing (DE); WAITL, Günter, 93049 Regensburg (DE)
(74) Vertreter: Epping - Hermann - Fischer
(86) Internationale Anmeldenummer: PCT/DE2001/003197
(87) Internationale Veröffentlichungsnummer: WO 2002/017405

(56) Entgegenhaltungen:
- EP-A- 0 588 040
- EP-A- 0 911 573
- EP-A- 0 921 568
- WO-A-80/01860
- DE-A- 3 829 553
- PATENT ABSTRACTS OF JAPAN vol. 014, no. 496 (E-0996), 29. Oktober 1990 (1990-10-29) -& JP 02 206179 A (HAMAMATSU PHOTONICS), 15. August 1990 (1990-08-15)
- PATENT ABSTRACTS OF JAPAN vol. 1999, no. 09, 30. Juli 1999 (1999-07-30) -& JP 11 121808 A (IDEC IZUMI CO), 30. April 1999 (1999-04-30)
- PATENT ABSTRACTS OF JAPAN vol. 008, no. 190 (E-263), 31. August 1984 (1984-08-31) -& JP 59 078584 A (TOSHIBA KK), 7. Mai 1984 (1984-05-07)
- PATENT ABSTRACTS OF JAPAN vol. 008, no. 226 (E-272), 17. Oktober 1984 (1984-10-17) -& JP 59 107584 A (CASIO KEISANKI KK), 21. Juni 1984 (1984-06-21)
- PATENT ABSTRACTS OF JAPAN vol. 1997, no. 02, 28. Februar 1997 (1997-02-28) -& JP 08 264841 A (MATSUSHITA ELECTR CO), 11. Oktober 1996 (1996-10-11)
- PATENT ABSTRACTS OF JAPAN vol. 2000, no. 01, 31. Januar 2000 (2000-01-31) & JP 11 284233 A (STANLEY ELECTRIC CO), 15. Oktober 1999 (1999-10-15)
- PATENT ABSTRACTS OF JAPAN vol. 1996, no. 09, 30. September 1996 (1996-09-30) -& JP 08 125228 A (MITSUMI ELECTRIC CO), 17. Mai 1996 (1996-05-17)
- PATENT ABSTRACTS OF JAPAN vol. 1995, no. 11, 26. Dezember 1995 (1995-12-26) -& JP 07 220972 A (TEIKOKU TSUSHIN KOGYO), 18. August 1995 (1995-08-18)
- PATENT ABSTRACTS OF JAPAN vol. 018, no. 388 (E-1581), 20. Juli 1994 (1994-07-20) & JP 06 112536 A (TOSHIBA LIGHTING&TECH), 22. April 1994 (1994-04-22)
- PATENT ABSTRACTS OF JAPAN vol. 006, no. 173 (E-129), 7. September 1982 (1982-09-07) -& JP 57 089276 A (ALPS ELECTRIC CO), 3. Juni 1982 (1982-06-03)

## Beschreibung

Die Erfindung betrifft ein optoelektronisches Bauelement mit einem Halbleiterchip, insbesondere ein oberflächenmontierbares optoelekronisches Bauelement für die Montage in Leiterplattendurchbrüchen. Sie betrifft weiterhin ein Verfahren zum Herstellen einer Mehrzahl von solchen optoelektronischen Bauelementen, ein Modul mit einer Mehrzahl von solchen optoelektronischen Bauelementen, und eine Anzeigevorrichtung sowie eine Beleuchtungs- oder Hinterleuchtungsvorrichtung mit einem solchen Modul.

Optoelektronische Bauelemente wie Leuchtdiodenbauelemente werden typischerweise in sogenannten Radialbauformen, die in Durchsteckmontage auf Leiterplatten befestigt werden, oder in oberflächenmontierbaren Bauformen angeboten. Man vergleiche dazu beispielsweise F. Möllmer, G. Waitl, SIEMENS SMT-TOPLED für die Oberflächenmontage, Siemens Components 29 (1991) Heft 4, Seiten 147 bis 149. Beide Bauformtypen lassen sich nur mit erheblichem technischen Aufwand in Leiterplatten-Ausnehmungen oder -Durchbrüchen anordnen.

JP02206179 offenbart ein optoelektronisches Bauelement mit einem Halbleiterchip, der auf einem flexiblen Chipträger montiert ist, bei dem auf einer ersten Hauptfläche Leiterbahnen zum elektrischen Anschließen des Halbleiterchips ausgebildet sind, und auf dem ein Gehäuserahmen angeordnet ist, wobei der Halbleiterchip sich im der von dem Gehäuserahmen umschlossenen Innenraum befindet und der Innenraum mit einer strahlungsdurchlässigen Füllmasse gefüllt ist.

JP59107584 und JP08264841 zeigen ähnliche optoelektronische Bauelemente gemäß dem Stand der Technik.

Die Aufgabe der vorliegenden Erfindung besteht insbesondere darin, eine Bauform für ein optoelektronisches Bauelement zu entwickeln, das eine geringe Bauhöhe ermöglicht, sich insbesondere auf einfache Weise in Leiterplatten-Ausnehmungen oder -Durchbrüchen positionieren läßt.

Diese Aufgabe wird durch ein optoelektronisches Bauelement mit den Merkmalen des Patentanspruches 1 gelöst. In Anspruch 7 ist ein bevorzugtes Modul mit einer Mehrzahl von erfindungsgemäßen optoelektronischen Bauelementen angegeben. Eine bevorzugte optische Anzeigevorrichtung mit einem solchen Mo-dul und eine Beleuchtungs- oder Hinterleuchtungsvorrichtung mit einem solchen Modul ist Gegenstand des Patentanspruches 10 beziehungsweise 11. Ein bevorzugtes Verfahren zum Herstellen einer Mehrzahl von erfindungsgemäßen optoelektronischen Bauelementen ist Gegenstand des Patentanspruches 14.

Durch die Ausbildung der Leiterbahnen auf dem flexiblen Chipträger wird der flexible Chipträger selbst ein Element des Bauelements, das vorzugsweise gleichzeitig zur Verpackung des Bauelements herangezogen werden kann.

Vorzugsweise werden derartige Bauelemente in einer Bestükkungsmaschine nicht von einem flexiblen Träger, beispielsweise einem Verpackungsgurt, abgehoben, sondern der flexible Chipträger wird entsprechend der Aufteilung des flexiblen Chipträgers in Bauelemente durchtrennt und die so gewonnenen Bauelemente auf eine Leiterplatte gesetzt. Separate Verpakkungsgurte sind bei einer erfindungsgemäßen Bauform vorteilhafterweise nicht erforderlich.

Bei einer bevorzugten Ausführungsform ist der flexible Chipträger eine Kunststoff-Folie. Dadurch ergeben sich besonders flache Bauelemente.

Bei einer bevorzugten Ausführungsform ist der Halbleiterchip ein Leuchtdiodenchip, der im Zentrum eines auf dem flexiblen Chipträger ausgebildeten Gehäuserahmens angeordnet ist. Dadurch ergeben sich Lichtquellen geringer Bauhöhe, die sich insbesondere für Leiterbahndurchbrüche in Mobilfunkgeräten zum Beispiel zur Hinterleuchtung einer Tastatur oder eines Displays eignen.

Vorteilhafte Weiterbildungen und Ausführungsformen der in den Ansprüchen 1, 7, 10, 11 und 14 genannten Gegenstände sind in den auf diese Ansprüche unmittelbar oder mittelbar zurückbezogenen abhängigen Ansprüchen angegeben.

Weitere vorteilhafte Ausgestaltungen und Vorteile der Erfindung ergeben sich aus den im Folgenden in Verbindung mit den Figuren 1 bis 6 beschriebenen Ausführungsbeispielen. Es zeigen:
- Figur 1: eine schematische Darstellung einer Aufsicht auf ein Leuchtdiodenbauelement gemäß der Erfindung;
- Figur 2: eine schematische Darstellung einer Querschnittsansicht des Leuchtdiodenbauelements von Figur 1;
- Figur 3: eine schematische Darstellung einer Aufsicht auf ein weiteres Ausführungsbeispiel eines Leuchtdiodenbauelements gemäß der Erfindung;
- Figur 4: eine schematische Darstellung einer Querschnittsansicht des Leuchtdiodenbauelements von Figur 3;
- Figur 5: eine schematische Schnittansicht eines Moduls mit einer Mehrzahl von erfindungsgemäßen optoelektronischen Bauelementen; und
- Figur 6: eine schematische Schnittansicht einer Flüssigkristallanzeige mit einer Hinterleuchtungsvorrichtung mit einer Mehrzahl von erfindungsgemäßen optoelektronischen Bauelementen.

In den verschiedenen Ausführungsbeispielen sind gleiche oder gleichwirkende Bestandteile jeweils mit denselben Bezugszeichen versehen.

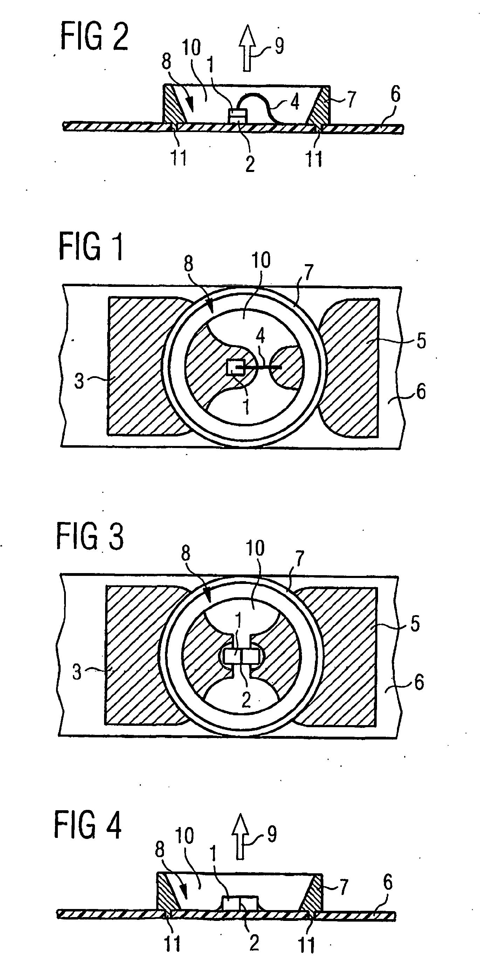

Das in den Figuren 1 und 2 dargestellte Bauelement ist beispielsweise ein Leuchtdiodenbauelement und weist einen strahlungsemittierenden Halbleiterchip 1 auf, der eine strahlungsemittierende aktive Schicht 2 enthält. Mit seiner Unterseite ist der Halbleiterchip 1 mit einer ersten Kontaktschicht 3 elektrisch leitend verbunden. Die Oberseite des Halbleiterchips 1 ist über einen Bonddraht 4 an eine zweite Kontaktschicht 5 angeschlossen. Die erste Kontaktschicht 3 und die zweite Kontaktschicht 5 sind beispielsweise aus Metallfolien hergestellt, die auf eine flexible Chipträgerfolie 6 auflaminiert sind.

Bei einem alternativen Halbleiterchip, der beide elektrischen Anschlußflächen auf der Oberseite aufweist, sind beide Anschlußflächen beispielsweise mittels Bonddrähten mit den Kontaktschichten 3 und 5 verbunden. Der Halbleiterchip kann hierbei ebenfalls auf einer der Kontaktflächen 3 und 5 oder zwischen den beiden Kontaktflächen 3 und 5 befestigt sein.

Der Halbleiterchip 1 befindet sich im Zentrum eines ringförmigen Reflektorrahmens 7 mit trichterartig ausgebildeter Innenseite 8, die vorzugsweise reflektierend ausgebildet ist. Dadurch ist der Reflektorrahmen 7 in der Lage, eine vom Halbleiterchip 1 zur Seite emittierte Strahlung zu einer Abstrahlrichtung 9 hin umzulenken.

Der von dem Reflektorrahmen 7 umschlossene Innenraum ist mit einer transparenten Füllmasse 10 gefüllt, in die Leuchtstoffpigmente eingebettet sein können, welche zumindest einen Teil der vom Halbleiterchip 1 ausgesandten Strahlung absorbieren und Strahlung anderer Wellenlänge als die absorbierte Strahlung reemittieren.

In den Figuren 3 und 4 ist ein abgewandeltes Ausführungsbeispiel des in Verbindung mit den Figuren 1 und 2 beschriebenen Leuchtdiodenbauelements dargestellt. Bei diesem Ausführungsbeispiel ist der Halbleiterchip 1 auf eine Seitenfläche gekippt an der ersten Kontaktschicht 3 und der zweiten Kontaktschicht 5 befestigt. In diesem Fall steht die aktive Schicht 2 in einem rechten Winkel zu der Chipträgerfolie 6. Diese Anordnung weist den Vorteil auf, daß keine Bonddrähte nötig sind, um den Halbleiterchip 1 an den Kontaktschichten zu befestigen. Ein Nachteil ist allerdings, daß eine Seite der aktiven Schicht 2 von der Chipträgerfolie 6 abgedeckt ist. Ferner sind die Oberseite und die Unterseite des Halbleiterchips 1 wenigstens teilweise mit Material bedeckt, das zur Befestigung des Halbleiterchips 1 an der ersten Kontaktschicht 3 und der zweiten Kontaktschicht 5 verwendet wird. Im Vergleich zu dem in den Figuren 1 und 2 dargestellten Ausführungsbeispiel ist daher bei der Leuchtdiode gemäß den Figuren 3 und 4 die Lichtausbeute geringer.

Als Material für die Chipträgerfolie 6 kommen vor allem temperaturfeste und metallisierbare Kunststoff-Folien in Frage. Beispielsweise kann die Chipträgerfolie 6 eine auf Epoxidharz basierende Chipträgerfolie sein oder aus Polyimid oder einem Polyester, zum Beispiel aus Poly-Ethylen-Naphthalat gefertigt sein. Als Werkstoff für den Reflektorrahmen 7 eignen sich insbesondere temperaturstabile und optisch reflektierende Materialien wie Poly-Phthalamid (PPA), Liquid Cristal Polymer (LCP) sowie Poly-Ether-Ether-Keton (PEEK). Daneben kommen auch weitere Thermoplaste in Frage, sofern sie nur temperaturstabil und optisch reflektierend sind. Derartige Thermoplaste können durch eingebettete Pigmente, wie beispielsweise TiO₂, eine sehr hohe Reflektivität aufweisen.

Die Materialien sind so gewählt, daß der Reflektorrahmen 7 auf der Chipträgerfolie 6 haftet. Um die Festigkeit der Verbindung zwischen Reflektorrahmen 7 und Chipträgerfolie 6 zu verbessern, ist in der Chipträgerfolie 6 mindestens ein Durchbruch oder eine Ausnehmung vorgesehen, in die ein Haltezapfen 11 des Reflektorrahmens 7 eingreift.

Als Material für die Füllmasse 10 kann eines der für die Herstellung on optoelektronischen Halbleiterbauelementen üblichen Reaktionsharze verwendet werden, wie beispielsweise Epoxidharz, Silikonharz oder acrylatähnliche Verbindungen in Frage.

Als Leuchtstoff eignet sich beispielsweise ein Pigment auf der Basis von Cer-dotiertem Yttrium-Aluminium-Granat (YAG:Ce), wie beispielsweise (Y_{1-x-y}GdₓTb_{y})₃Al₅O₁₂:Ce, mit 0≤x≤1, 0≤y≤1 und x+y≤1.

Zusätzlich zum Leuchtstoff kann sich in der Füllmasse 10 auch noch ein Diffusormaterial wie Titandioxid, Bariumoxid, Zirkoniumdioxid oder Dialuminiumtrioxid befinden. Dieses Diffusormaterial trägt vorteilhafterweise zu einem homogeneren Erscheinungsbild der Lichtabstrahlung bei. Soll keine Strahlungskonversion erfolgen, sondern nur eine Streuung der ausgesandten Strahlung, so kann dazu in der Füllmasse 10 nur Diffusormaterial und kein Leuchtsoff enthalten sein.

Zur Herstellung der Leuchtdioden wird vorzugsweise zunächst auf ein Chipträgerfolienband eine Metallfolie auflaminiert und anschließend mit einer Photolackschicht beschichtet. Die Photolackschicht wird belichtet und anschließend werden die Photolackschicht und die Metallfolie durch ein an sich bekanntes Ätzverfahren strukturiert, so dass eine Vielzahl von Kontaktschichtpaaren 3 und 5 entsteht. Daraufhin werden die Reste der Photolackschicht entfernt und Reflektorrahmen 7 auf das Chipträgerfolienband beispielsweise mittels Spritzpressen oder Spritzgießen aufgebracht. Zur Verankerung der Reflektorrahmen 7 an der Chipträgerfolie 6 sind in dieser Durchbrüche ausgebildet, in die Zapfen 11 der Reflektorrahmen 7 eingreifen können.

Alternativ zum Spritzgießen oder Spritzpressen des Reflektorrahmens ist ein einfaches Aufstecken und Verkleben von vorgefertigten Reflektorrahmen 7 auf die Chipträgerfolie 6 denkbar.

Nachfolgend erfolgt das Aufsetzen jeweils des Halbleiterchips 1 auf das Chipträgerfolienband. Nach dem jeweiligen Bonden des Halbleiterchips 1 und dem Herstellen der Drahtverbindung 4 zwischen dem Oberseitenkontakt des Halbleiterchips 1 und der Kontaktschicht 5 wird der Innenraum des zugehörigen Reflektorrahmens 7 mit der Füllmasse 10 gefüllt. Die Chipträgerfolie 6 wird anschließend gefaltet oder aufgerollt, so daß eine handhabbare Verpackungseinheit für die Leuchtdioden entsteht.

Alternativ zur oben erläuterten Vorgehensweise kann der jeweilige Reflektorrahmen 7 erst nach der Montage des zugehörigen Halbleiterchips 1 auf der Chipträgerfolie 6 aufgebracht werden.

Bei den in den Figuren 1 bis 4 dargestellten Ausführungsbeispielen ist die Chipträgerfolie 6 bandförmig ausgebildet, wobei die Halbleiterchips 1 auf der Chipträgerfolie 6 aufgereiht sind. Zusätzlich dazu kann die Chipträgerfolie 6 auch so breit gewählt werden, daß mehrere Reihen von Leuchtdiodenchips nebeneinander Platz finden.

Außerdem ist es möglich, mehrere Halbleiterchips 1 innerhalb eines einzigen Reflektors 7 anzuordnen und auf diese Weise unter anderem Leuchtdiodenbauelemente zu erhalten, die in verschiedenen Farben leuchten oder die mischfarbiges Licht aussenden.

Ferner ist es bei der erfindungsgemäßen Bauform auf einfache Weise möglich, auch die Rückseite der Chipträgerfolie 6 insbesondere ganzflächig mit einer Metallisierungsschicht oder Metallisierungsstruktur zu versehen, die zur Abschirmung von Störwellen bei Hochfrequenzanwendungen dienen.

Die hier beschriebenen Bauformen zeichnen sich durch einen vergleichesweise geringen Platzbedarf aus und durch die Möglichkeit der nahezu vollständigen Versenkung in einem Leiterplattendurchbruch. Die flexible Chipträgerfolie 6 kann zudem ohne Schwierigkeiten an verschiedene räumliche Gegebenheiten angepaßt werden. Da ferner die Chipträgerfolie 6 im allgemein dünn ausgebildet ist, weisen die Leuchtdioden im allgemein eine geringe Bauhöhe auf. Es ergeben sich daher besonders flache Bauelemente.

Ein weiterer Vorteil ist, dass die Chipträgerfolie 6 und der Reflektorrahmen 7 aus Materialien hergestellt werden können, die gleiche oder zumindest sehr ähnliche thermische Ausdehnungskoeffizienten aufweisen. Dadurch wird die Zuverlässigkeit der Leuchtdioden bei Temperaturzyklen sehr hoch.

Schließlich ist noch von Vorteil, daß die mittels der Chipträgerfolie 6 hergestellten Leuchtdiodenbauelemente zum Verpacken und zum Transport keines besonderen zusätzlichen Verpackungsgurtes mehr bedürfen. Die elastische Chipträgerfolie kann vorteilhafterweise die Rolle eines Verpackungsgurtes, wie er in der Leadframe-Technik notwendig ist, vollständig übernehmen.

Das Chipträgerfolienband wird vorzugweise erst kurz vor der Montage der Bauelemente in die gewünschten einzelnen Bauelemente oder Bauelementgruppen, bestehend aus einer Mehrzahl von Bauelementen durchtrennt.

Falls derart hergestellte Leuchtdiodenbauelemente für eine Tastaturhinterleuchtung beispielsweise eines Mobilfunkgeräts verwendet werden sollen, kann die Chipträgerfolie an der Montagelinie für die Mobilfunkgerät zerteilt werden und die vorgesehenen Gruppen von Leuchtdioden gemeinsam in das Mobilfunkgerät eingesetzt werden. Zweckmäßigerweise sind bei einer derartigen Anwendung bereits die zur Ansteuerung der Leuchtdiodenchips erforderlichen Schaltkreise auf der Chipträgerfolie 6 ausgebildet.

Das Verfahren wurde oben anhand von Leuchtdioden erläutert. Es ist jedoch möglich auch andere Halbleiterchips auf die beschriebene Art und Weise zu verpacken und handhabbar zu machen.

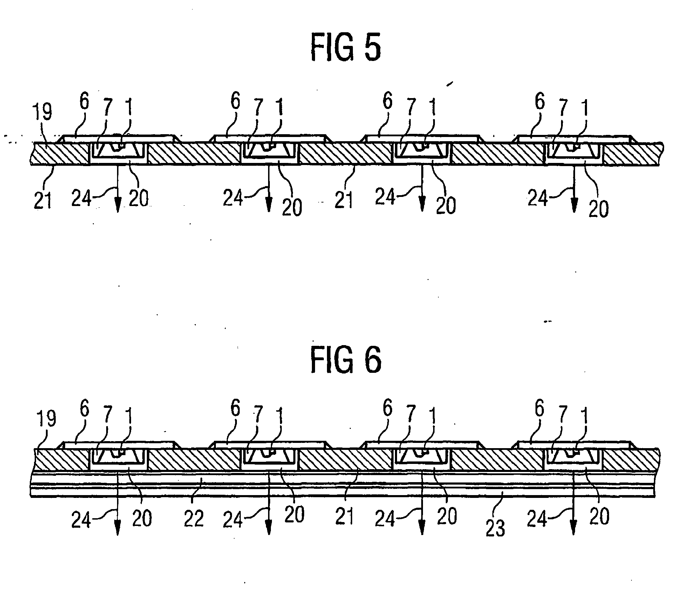

In Figur 5 ist ein Modul mit einer Mehrzahl von erfindungsgemäßen Bauelementen gezeigt. In einem Trägerelement 19, beispielsweise einer Platine, ist eine Mehrzahl von Durchbrüchen 20 gebildet. Weiterhin weist das Trägerelement 19 eine Abstrahlungsseite 21 auf.

Auf der der Abstrahlungsseite 21 gegenüberliegenden Seite des Trägerelements 19 ist eine Mehrzahl erfindungsgemäßer strahlungsemittierender Bauelemente befestigt, wobei jeweils ein Gehäuserahmen 7 eines strahlungsemittierenden Bauelements in einen der Durchbrüche 20 hineinragt und die Abstrahlungsrichtung 24 durch die Durchbrüche 20 hindurch verläuft.

Der jeweilige Chipträger 6 liegt mit seinen elektrischen Leiterbahnen 3 und 5 des Bauelements auf der der Abstrahlungsseite 21 gegenüberliegenden Oberfläche des Trägerelements 19 auf. Zur Befestigung der Bauelemente können Klebeverbindungen oder Lötverbindungen dienen. Auf Grund des vorzugsweise eben ausgebildeten Chipträgers 6, ist der Platzbedarf horizontal und vertikal deutlich geringer als bei Bauelementen nach dem Stand der Technik. Insbesondere ermöglicht die Erfindung eine zumindest teilweise versenkte Montage der Bauelemente.

Auf Grund des flexibel ausgebildeten Chipträgers 6 ist das Bauelement ausreichend flexibel, um Verspannungen und Verformungen elastisch oder gegebenenfalls plastisch abzufangen, ohne daß schädliche Verspannungen auf das Gehäuse oder einen darin befindlichen strahlungsemittierenden Halbleiterchip übertragen werden. Diese Montageanordnung ist insbesondere für dicht gepackte flache Anzeigemodule geeignet.

Vorzugsweise ist der Träger oder zumindest die abstrahlungsseitige Oberfläche strahlungsabsorbierend, beispielsweise geschwärzt ausgeführt, so daß der Kontrast der einzelnen strahlungsemittierenden Bauelemente gegenüber der Umgebung erhöht wird. Dies ist insbesondere bei Anordnungen vorteilhaft, die als Anzeigevorrichtung vorgesehen sind.

In Figur 6 ist eine weitere Anordnung erfindungsgemäßer Bauelemente gezeigt. Im Unterschied zur vorangehend beschriebenen Anordnung ist die in Figur 6 gezeigte Anordnung insbesondere als Hintergrundbeleuchtung, beispielsweise für eine Flüssigkristallanzeige, geeignet.

Auf einem Träger 19 sind wie im vorigen Ausführungsbeispiel erfindungsgemäße strahlungsemittierende Bauelemente versenkt montiert. Abstrahlungsseitig ist dem Träger bzw. den Bauelementen eine Streuplatte 22 nachgeordnet. Weiterhin ist der Träger 19 oder zumindest die abstrahlungsseitige Oberfläche des Trägers 19 vorzugsweise gleichmäßig diffus reflektierend, beispielsweise weiß ausgeführt. Dadurch wird eine weitgehend homogene Hinterleuchtung in äußerst flacher Bauweise ermöglicht. Der Streuplatte nachgeordnet ist beispielsweise eine zu beleuchtende Flüssigkristall-Anzeige (LCD) 23.

Der Träger 19 kann sowohl, wie oben beschrieben, starr als auch flexibel, zum Beispiel in Form einer Kunststoff- oder Keramikfolie ausbildet sein, so dass ein Hinterleuchtungsoder Anzeigemodul auf einfache Weise verschiedenen Formen angefaßt und vorteilhafterweise sogar an sich verändernde Flächen montiert werden kann.

Die Erläuterung der Erfindung an Hand der gezeigten Ausführungsbeispiele ist selbstverständlich nicht als Beschränkung der Erfindung hierauf zu verstehen. Beispielsweise kann der Halbleiterchip unmittelbar auf einer Chipmontagefläche des Chipträgers montiert, zum Beispiel geklebt, sein und der Halbleiterchip ausschließlich mittels Drahtverbindungen mit den Leiterbahnen elektrisch verbunden sein. Der Halbleiterchip kann ebenso auf einem separaten thermischen Anschluß montiert sein, der in den Chipträger eingebettet ist, und wiederum mittels Dratverbindungen elektrisch an die Leiterbahnen angeschlossen sein.

## Patentansprüche

1. Optoelektronisches Bauelement mit einem Halbleiterchip (1), der auf einem flexiblen Chipträger (6) montiert ist, bei dem auf einer ersten Hauptfläche Leiterbahnen (3, 5) zum elektrischen Anschließen des Halbleiterchips (1) ausgebildet sind, und auf dem ein Gehäuserahmen (7) angeordnet ist, wobei der Halbleiterchip (1) sich in dem von dem Gehäuserahmen (7) umschlossenen Innenraum befindet und der Innenraum mit einem strahlungsdurchlässigen Medium, insbesondere mit einer Füllmasse (10) gefüllt ist,
**dadurch gekennzeichnet, dass**
in dem flexiblen Chipträger (6) mindestens ein Durchbruch oder eine Ausnehmung vorgesehen ist, und der Gehäuserahmen (7) mindestens einen Haltezapfen (11) aufweist, wobei jeweils ein Haltezapfen (11) des Gehäuserahmens (7) in einen Durchbruch oder eine Ausnehmung des flexiblen Chipträgers (6) eingreift.

2. Optoelektronisches Bauelement nach Anspruch 1,
bei dem der Halbleiterchip ein Leuchtdiodenchip (1) ist.

3. Optoelektronisches Bauelement nach Anspruch 2,
bei dem die Innenfläche des Gehäuserahmens (7) als Reflektor ausgebildet ist, der eine von dem Leuchtdiodenchip (1) seitlich abgestrahlte elektromagnetische Strahlung zu einer Abstrahlrichtung (9) hin umlenkt.

4. Optoelektronisches Bauelement nach Anspruch 1,
bei dem die Innenfläche des Gehäuserahmens (7) als Reflektor ausgebildet ist, der eine von außerhalb des Bauelements auftreffende, vom Halbleiterchip (1) zu empfangende elektromagnetische Strahlung zu diesem hin umlenkt.

5. Optoelektronisches Bauelement nach einem der vorhergehenden Ansprüche,
bei dem auf einer der ersten Hauptfläche gegenüberliegenden zweiten Hauptfläche des Chipträgers (6) eine Abschirmungsschicht zur Abschirmung von elektromagnetischen Störwellen bei Hochfrequenzanwendungen ausgebildet ist.

6. Optoelektronisches Bauelement nach einem der vorhergehenden Ansprüche,
bei dem die Füllmasse ein Leuchtstoffmaterial und/oder Diffusormaterial enthält.

7. Modul mit einer Mehrzahl von optoelektronischen Bauelementen nach einem der Ansprüche 2 bis 4 oder nach Anspruch 5 oder 6, jeweils unter direktem oder indirektem Rückbezug auf einen der Ansprüche 2 bis 4, bei dem ein Trägerelement (19) mit einer Mehrzahl von Durchbrüchen (20) vorgesehen ist und die Bauelemente jeweils mit dem Chipträger (6) auf einer einer abstrahlungsseitigen Oberfläche gegenüberliegenden Seite des Trägerelements (19) befestigt sind, derart, dass der Gehäuserahmen (7) jeweils in einen der Durchbrüche (20) ragt oder diesen durchragt.

8. Modul nach Anspruch 7, bei dem das Trägerelement (19) flexibel ausgebildet ist.

9. Modul nach Anspruch 7 oder 8, bei dem auf dem Trägerelement (19) elektrische Leitungsstrukturen zum elektrischen Anschließen der optoelektronischen Bauelemente ausgebildet sind.

10. Optische Anzeigevorrichtung mit einem Modul nach einem der Ansprüche 7 bis 9, bei dem die abstrahlungsseitige Oberfläche des Trägerelements (19) strahlungsabsorbierend, insbesondere geschwärzt, ist.

11. Beleuchtungs- oder Hinterleuchtungsvorrichtung mit einem Modul nach einem der Ansprüche 7 bis 9, bei dem die abstrahlungsseitige Oberfläche des Trägerelements (19) diffus reflektierend, insbesondere weiß, ist.

12. Beleuchtungs- oder Hinterleuchtungsvorrichtung nach Anspruch 11, bei der dem Trägerelement (19) abstrahlungsseitig eine Streuplatte (22) nachgeordnet ist.

13. Flüssigkristallanzeige, bei der auf einer von einer Betrachtungsseite abgewandten Seite eine Vorrichtung gemäß Anspruch 11 oder 12 angeordnet ist.

14. Verfahren zum Herstellen einer Mehrzahl von optoelektronischen Bauelementen nach einem der Ansprüche 1 bis 6 mit folgenden Verfahrensschritten:
a) Bereitstellen eines flexiblen Chipträgerfolienbandes (6);
b) Herstellen einer Mehrzahl von Leiterbahnpaaren (3,5) für jeweils einen Halbleiterchip (1) auf dem flexiblen Chipträgerfolienband (6);
c) Ausbilden jeweils eines Gehäuserahmens (7) an jeder Stelle des flexiblen Chipträgerfolienbandes (6), an der ein Halbleiterchip (1) oder eine Halbleiterchipanordnung eines einzelnen optoelektronischen Bauelements vorgesehen ist, insbesondere mittels Spritzgießen oder Spritzpressen;
d) Montieren einer Mehrzahl von Halbleiterchips (1) auf das flexible Chipträgerfolienband (6); und
e) zumindest teilweises Füllen der von den Gehäuserahmen (7) gebildeten Strahlungsfenster mit einer Füllmasse (10); **dadurch gekennzeichnet, dass** das flexible Chipträgerfolienband (6) mindestens einen Durchbruch oder eine Ausnehmung an jeder Stelle, an der ein Halbleiterchip (1) oder eine Halbleiterchipanordnung eines einzelnen optoelektronischen Bauelements vorgesehen ist, aufweist, und der Gehäuserahmen (7) mindestens einen Haltezapfen (11) aufweist, wobei jeweils ein Haltezapfen (11) des Gehäuserahmens (7) in einen Durchbruch oder eine Ausnehmung des flexiblen Chipträgerfolienbandes eingreift.

15. Verfahren nach Anspruch 14, bei dem das flexible Chipträgerfolienband (6) mit den montierten und verkapselten Halbleiterchips zu einer Verpackungseinheit mit einer Mehrzahl von oberflächenmontierbaren optoelektronischen Bauelementen aufgerollt wird.

## Claims

1. Optoelectronic component comprising a semiconductor chip (1), which is mounted on a flexible chip carrier (6), in the case of which conductor tracks (3, 5) for electrically connecting the semiconductor chip (1) are formed on a first main surface, and on which a housing frame (7) is arranged, wherein the semiconductor chip (1) is situated in the interior enclosed by the housing frame (7) and the interior is filled with a radiation-transmissive medium, in particular with a filling compound (10),
**characterized in that**
at least one cutout or recess is provided in the flexible chip carrier (6), and the housing frame (7) has at least one holding pin (11), wherein a holding pin (11) of the housing frame (7) respectively engages into a cutout or recess of the flexible chip carrier (6).

2. Optoelectronic component according to Claim 1, wherein the semiconductor chip is a light-emitting diode chip (1).

3. Optoelectronic component according to Claim 2, wherein the inner surface of the housing frame (7) is embodied as a reflector that deflects an electromagnetic radiation emitted laterally by the light-emitting diode chip (1) towards an emission direction (9).

4. Optoelectronic component according to Claim 1, wherein the inner surface of the housing frame (7) is embodied as a reflector that deflects an electromagnetic radiation which impinges from outside the component and which is to be received by the semiconductor chip (1) towards the latter.

5. Optoelectronic component according to any of the preceding claims,
wherein a screening layer for screening electromagnetic interference waves in radio-frequency applications is formed on a second main surface of the chip carrier (6) situated opposite the first main surface.

6. Optoelectronic component according to any of the preceding claims,
wherein the filling compound contains a phosphor material and/or diffuser material.

7. Module comprising a plurality of optoelectronic components according to any of Claims 2 to 4 or according to Claim 5 or 6, in each case referring back directly or indirectly to any of Claims 2 to 4, wherein a carrier element (19) having a plurality of cutouts (20) is provided and the components are fixed in each case with the chip carrier (6) on a side of the carrier element (19) situated opposite an emission side in such a way that the housing frame (7) in each case projects into or projects through one of the cutouts (20).

8. Module according to Claim 7, wherein the carrier element (19) is embodied in a flexible fashion.

9. Module according to Claim 7 or 8, wherein electrical conduction structures for electrically connecting the optoelectronic components are formed on a carrier element (19).

10. Optical display device comprising a module according to any of Claims 7 to 9, wherein a surface of the carrier element (19) on the emission side is radiation-absorbing, in particular blackened.

11. Lighting or backlighting device comprising a module according to any of Claims 7 to 9, wherein a surface of the carrier element (19) on the emission side is diffusely reflective, in particular white.

12. Lighting or backlighting device according to Claim 11, wherein a diffusing plate (22) is disposed downstream of the carrier element (19) on the emission side.

13. Liquid crystal display, wherein a device according to Claim 11 or 12 is arranged on a side facing away from a viewing side.

14. Method for producing a plurality of optoelectronic components according to any of Claims 1 to 6 comprising the following method steps:
a) providing a flexible chip carrier film strip (6);
b) producing a plurality of conductor track pairs (3, 5) respectively for a semiconductor chip (1) on the flexible chip carrier film strip (6);
c) forming a housing frame (7) respectively at each location of the flexible chip carrier film strip (6) at which a semiconductor chip (1) or a semiconductor chip arrangement of an individual optoelectronic component is provided, in particular by means of injection moulding or transfer moulding;
d) mounting a plurality of semiconductor chips (1) onto the flexible chip carrier film strip (6); and
e) at least partly filling the radiation windows formed by the housing frames (7) with a filling compound (10);
**characterized in that**
the flexible chip carrier film strip (6) has at least one cutout or recess at each location at which a semiconductor chip (1) or a semiconductor chip arrangement of an individual optoelectronic component is provided, and the housing frame (7) has at least one holding pin (11), wherein a holding pin (11) of the housing frame (7) respectively engages into a cutout or recess of the flexible chip carrier film strip.

15. Method according to Claim 14, wherein the flexible chip carrier film strip (6) with the mounted and encapsulated semiconductor chips is rolled up to form a packaging unit comprising a plurality of surface-mountable optoelectronic components.

## Revendications

1. Composant optoélectronique comportant une puce à semi-conducteur (1) montée sur un support de puce souple (6), dans lequel des pistes conductrices (3, 5) destinées à connecter électriquement la puce à semi-conducteur (1) sont formées sur une première surface principale, et sur lequel est disposé un châssis de boîtier (7), dans lequel ladite puce à semi-conducteur (1) se trouve dans l'espace intérieur entouré par le châssis de boîtier (7) et l'espace intérieur est rempli d'un milieu transparent aux rayonnements, notamment une masse de remplissage (10), **caractérisé en ce qu'**au moins une traversée ou un évidemment est prévu dans le support de puce souple (6), et **en ce que** le châssis de boîtier (7) comprend au moins une broche de retenue (11), dans lequel une broche de retenue (11) respective du châssis de boîtier (7) s'engage dans une traversée ou un évidemment du support de puce souple (6).

2. Composant optoélectronique selon la revendication 1, dans lequel la puce à semi-conducteur est une puce de diode électroluminescente (1).

3. Composant optoélectronique selon la revendication 2, dans lequel la surface intérieure du châssis de boîtier (7) est réalisée sous la forme d'un réflecteur qui dévie un rayonnement électromagnétique rayonné latéralement par la puce de diode électroluminescente (1) dans une direction de rayonnement (9).

4. Composant optoélectronique selon la revendication 1, dans lequel la surface intérieure du châssis de boîtier (7) est réalisée sous la forme d'un réflecteur qui dévie le rayonnement électromagnétique incident de l'extérieur du composant et devant être reçu par la puce à semi-conducteur (1) vers celle-ci.

5. Composant optoélectronique selon l'une quelconque des revendications précédentes, dans lequel un blindage destiné au blindage contre des ondes électromagnétiques parasites est réalisé sur une seconde surface principale opposée à la première surface principale du support de puce (6).

6. Composant optoélectronique selon l'une quelconque des revendications précédentes, dans lequel la masse de remplissage contient un matériau luminescent et/ou un matériau diffusant.

7. Module comportant une pluralité de composants optoélectroniques selon l'une quelconque des revendications 2 à 4 ou selon la revendication 5 ou 6, respectivement en référence directe ou indirecte à l'une quelconque des revendications 2 à 4, dans lequel un élément de support (19) ayant une pluralité de traversées (20) est fourni et les composants sont respectivement fixés avec le support de puce (6) sur une face opposée à une surface du côté rayonnant de l'élément de support (19) de telle manière que le châssis de boîtier (7) fasse respectivement saillie dans ou à travers l'une des traversées (20).

8. Module selon la revendication 7, dans lequel l'élément de support (19) est réalisé de manière à être souple.

9. Module selon la revendication 7 ou 8, dans lequel des structures électriquement conductrices destinées à connecter électriquement les composants optoélectroniques sont réalisées sur l'élément de support (19).

10. Dispositif d'affichage optique comportant un module selon l'une quelconque des revendications 7 à 9, dans lequel la surface du côté rayonnant de l'élément de support (19) est du type absorbant les rayonnements, notamment noircie.

11. Dispositif d'éclairage ou de rétroéclairage comportant un module selon l'une quelconque des revendications 7 à 9, dans lequel la surface du côté rayonnant de l'élément de support (19) est du type produisant une réflexion diffuse, notamment blanche.

12. Dispositif d'éclairage ou de rétroéclairage comportant un module selon la revendication 11, dans lequel une plaque diffusante (22) est disposée du côté rayonnant en aval de l'élément de support (19).

13. Afficheur à cristaux liquides, dans lequel un dispositif selon la revendication 11 ou 12 est disposé sur une face opposée à un côté d'observation.

14. Procédé de fabrication d'une pluralité de composants optoélectroniques selon l'une quelconque des revendications 1 à 6, comportant les étapes suivantes :
a) fournir une bande de feuille de support de puce souple (6) ;
b) préparer une pluralité de paires de traces conductrices (3, 5) respectivement destinées à une puce à semi-conducteur (1) sur la bande de feuille de support de puce souple (6) ;
c) former respectivement un châssis de boîtier (7) a chaque position de la bande de feuille de support de puce souple (6), à laquelle il est prévu une puce à semi-conducteur (1) ou un dispositif à puce à semi-conducteur d'un composant optoélectronique individuel, notamment par moulage par injection ou moulage par transfert ;
d) monter une pluralité de puces à semi-conducteur (1) sur la bande de feuille de support de puce (6) ; et
e) remplir au moins partiellement la fenêtre de rayonnement formée par le châssis de boîtier (7) d'une masse de remplissage (10) ;
**caractérisé en ce que** la bande de feuille de support de puce (6) comprend au moins une traversée ou un évidemment à chaque position à laquelle il est prévu une puce à semi-conducteur (1) ou un dispositif à puce à semi-conducteur d'un composant optoélectronique individuel, et **en ce que** le châssis de boîtier (7) comprend au moins une broche de retenue (11), dans lequel une broche de retenue (11) respective du châssis de boîtier (7) est engagée dans une traversée ou un évidemment de la bande de feuille de support de puce.

15. Procédé selon la revendication 14, dans lequel la bande de feuille de support de puce (6) comportant les puces à semi-conducteur montées et encapsulées est enroulée en une unité de conditionnement comportant une pluralité de composants optoélectroniques pouvant être montés en surface.
